# EUROPEAN PATENT SPECIFICATION

(11) **EP 2 894 547 B1**
(45) Date of publication and mention of the grant of the patent: **03.01.2018**
(21) Application number: 12884319.0
(22) Date of filing: 05.09.2012
(51) Int. Cl.: G06F 3/01, G06F 3/023, G06F 17/27, H03M 11/12

(54) **CHARACTER INPUT DEVICE, CHARACTER INPUT METHOD OF CHARACTER INPUT DEVICE, AND NON-TRANSITORY COMPUTER-READABLE MEDIUM**
ZEICHENEINGABEVORRICHTUNG, ZEICHENEINGABEVERFAHREN FÜR DIE ZEICHENEINGABEVORRICHTUNG UND NICHTTEMPORÄRES COMPUTERLESBARES MEDIUM
DISPOSITIF D'ENTRÉE DE CARACTÈRES, PROCÉDÉ D'ENTRÉE DE CARACTÈRES POUR DISPOSITIF D'ENTRÉE DE CARACTÈRES ET SUPPORT DE STOCKAGE NON-TRANSITOIRE LISIBLE PAR ORDINATEUR

(43) Date of publication of application: 15.07.2015
(73) Proprietor: NEC Corporation, Tokyo 108-8001 (JP)
(72) Inventor: YAMADA, Tsutomu, Kawasaki-shi Kanagawa 211-8666 (JP)
(74) Representative: Vossius & Partner Patentanwälte Rechtsanwälte mbB
(86) International application number: PCT/JP2012/005636
(87) International publication number: WO 2014/037976

(56) References cited:
- WO-A1-2011/091603
- JP-A- H09 294 170
- JP-A- H11 212 705
- JP-A- 2008 083 848
- JP-A- 2008 158 573
- JP-A- 2009 301 167
- JP-A- 2010 079 832
- US-A1- 2009 193 332

## Description

### Technical Field

The present invention relates to a character input device, a character input method of the character input device and a non-transitory computer readable medium.

### Background Art

A technique which allows users to more easily input characters in character input devices such as mobile terminals, personal computers and game machines has been developed.

For example, JP-2010-79832 A (Patent Literature 1) discloses a character input device which can correct an erroneous input which occurs when characters are inputted using a numerical keypad operating like a toggle.

For example, when a user inputs " 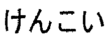 " even though the user intended to input " 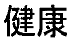 ", the user deletes the last character " 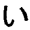 " of " 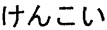 ". Then, the deleted character is stored in the character input device, and the character input device creates conversion candidate character strings by combining characters such as " 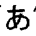 " and " 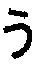 " other than the deleted character with " 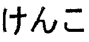 " and displays the conversion candidate character strings. The user selects " 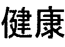 " from these conversion candidate character strings. Consequently, the user can input " 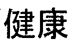 " without inputting a character " 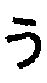 " again.

Further, JP-S60-24621 A (Patent Literature 2) discloses a Japanese sentence creating device which creates Japanese sentences by inputting a pronunciation of a Japanese word and converting an inputted pronunciation string into a representation including a mixture of kanji and kana characters.

When, even though, for example, an operator inputs " 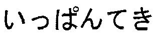 " to input a word " 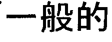 ", the operator cannot covert a hiragana string " 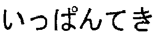 " into a kanji string, the operator deletes the portion " 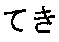 ". In this case, the Japanese sentence creating device stores the characters " 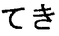 ".

Next, when the operator converts a character string " 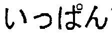 " into " 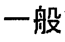 ", and determines the character string, the Japanese sentence creating device retrieves " 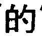 " from the stored character string " 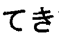 " and displays " 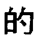 ". Consequently, the operator can input the character " 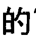 " without inputting " 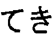 " again.

WO 2011/091603 A1 relates to a method for facilitating text editing wherein a deletion operation with respect to a language unit is detected and input string information corresponding to the language unit are retrieved from a memory. US 2009/193332 A1 relates to a method and apparatus for editing letters and which letters are edited through the use of an auto complete operation after input of a backspace operation.

### Summary of Invention

### Technical Problem

When a user deletes inputted characters using a character input device, the user generally deletes the characters by pushing a delete key. Although the user needs to push the delete key a number of times corresponding to the number of characters which need to be deleted in order to delete a plurality of characters, the user may push the delete key more than this number of times and deletes a necessary character in some cases. In these cases, the user needs to display the deleted character again by inputting the necessary character again or operating a dedicated key provided to an input terminal. Hence, there is a problem that inputting only necessary characters again requires labor.

However, the techniques disclosed in Patent Literatures 1 and 2 do not suppose the case of the above problem and cannot solve the above problem.

According to Patent Literature 1, when, for example, the user deletes " 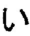 " from the character string " 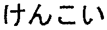 ", character strings displayed as input candidates do not include the deleted character " 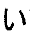 ". According to Patent Literature 2, while " 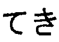 " deleted from the character string " 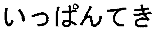 " is displayed as an input candidate, a portion of " 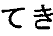 " is not displayed as an input candidate. That is, according to Patent Literatures 1 and 2, the user cannot easily input again characters which have been deleted even though the characters are necessary.

The present invention has been made to solve this problem, and an object of the present invention is to provide a character input device, a character input method and a non-transitory computer readable medium which can easily input only necessary characters again.

### Solution to Problem

The invention is defined by the appended independent claims. The dependent claims define preferred embodiments.

The present invention according to a first aspect includes a character input device. The character input device includes: an input unit, a display unit, a deletion character information storage unit, and a control unit. The input unit, receives an input of a character and an input of deletion of the character. The display unit displays the character inputted through the input unit. The deletion character information storage unit stores deletion character information deleted in response to the input of the deletion through the input unit. The control unit determines whether or not character information inputted through the input unit and at least a portion of the deletion character information stored in the deletion character information storage unit match, and displays a portion of the deletion character information as an input candidate on the display unit when determining the match.

The present invention according to a second aspect includes a character input device. The character input device includes: an input unit, a display unit, a deletion character information storage unit, and a control unit. The input unit receives an input of a character and an input of deletion of the character. The display unit displays the character inputted through the input unit. The deletion character information storage unit deletion character information storage unit stores deletion character information deleted in response to the input of the deletion through the input unit. The control unit determines whether or not character information inputted through the input unit and at least a portion of character information for conversion-inputting the deletion character information match, and displays a portion of the deletion character information as an input candidate on the display unit when determining the match.

The present invention according to a third aspect includes a character input method of a character input device. This method includes the following steps (a), (b) and (c):
(a) storing deleted deletion character information,
(b) determining whether or not character information inputted after the deletion and at least a portion of the stored deletion character information match, and
(c) displaying a portion of the deletion character information as an input candidate when determining the match.

The present invention according to a fourth aspect includes a non-transitory computer readable medium. The computer readable medium stores a program which causes the character input device to perform the above method according to the third aspect of the present invention.

The present invention according to a fifth aspect includes a character input method of a character input device. This method includes the following steps (a), (b) and (c):
(a) storing deleted deletion character information,
(b) determining whether or not character information inputted after the deletion and at least a portion of character information for conversion-inputting the stored deletion character information match; and
(c) displaying a portion of the deletion character information as an input candidate when determining the match.

The present invention according to a sixth aspect includes a non-transitory computer readable medium. The computer readable medium stores a program which causes the character input device to perform the above method according to the fifth aspect of the present invention.

### Advantageous Effects of Invention

The present invention can provide a character input device, a character input method of the character input device and a non-transitory computer readable medium which can easily input only necessary characters in a deleted character string again.

### Brief Description of Drawings

Fig. 1 is a block diagram illustrating an entire configuration example of the character input device according to a first embodiment.
Fig. 2 is a flowchart illustrating processing of a control unit according to the first embodiment.
Fig. 3 is a block diagram illustrating an entire configuration example of a mobile terminal according to a second embodiment.
Fig. 4 is an entire view of a mobile terminal according to the second embodiment.
Fig. 5 is a flowchart illustrating processing of a control unit according to the second embodiment.
Fig. 6 is a flowchart illustrating processing of a control unit according to a third embodiment.
Fig. 7 is a flowchart illustrating processing of a control unit according to a fourth embodiment.

### Description of Embodiments

### First Embodiment

A character input device according to the present embodiment stores deleted deletion character information and, when inputted character information and at least a portion of the stored deletion character information match, displays a portion of the deletion character information as an input candidate. Consequently, a user can easily input only necessary characters again instead of all characters of a deleted character string. Embodiments of the present invention will be described below with reference to the drawings.

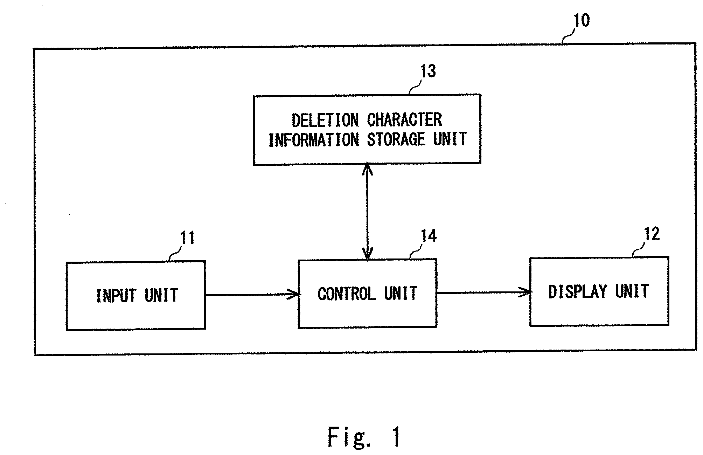

Fig. 1 is a block diagram illustrating an entire configuration example of the character input device according to the present embodiment. A character input device 10 according to the present embodiment has an input unit 11, a display unit 12, a deletion character information storage unit 13 and a control unit 14.

The character input device 10 is a device such as a mobile terminal, a game machine and a PC (Personal Computer) which allows the user to input characters.

The input unit 11 receives an input of characters and an input of deletion of characters from the user. After receiving the input, the input unit 11 outputs character information inputted by the user or character information (also referred to as deletion character information below) whose deletion is inputted, to the control unit 14. A specific example of the input unit 11 may be a keyboard or an input button which performs a key operation by way of pushing or a pointing device such a mouse, a touch panel or a rotatable dial.

The display unit 12 displays a character inputted from the input unit 11, and cancels display of a character deleted by the input unit 11. In addition, the display unit 12 may display other information such as a time and an address under control of the control unit 14. More specifically, the display unit 12 is a display such as a normal liquid crystal display and an organic EL display which can display monochrome or color images, yet is not limited to this.

In addition, the input unit 11 and the display unit 12 do not need to be physically separate. When, for example, the character input device 10 is a character input device such as a tablet PC or a smartphone, the input unit 11 and the display unit 12 may be integrated and provided as a touch panel to the character input device 10.

The deletion character information storage unit 13 stores deletion character information deleted in response to a user's input of deletion to the input unit 11. Further, the deletion character information storage unit 13 outputs the stored deletion character information under control of the control unit 14. The deletion character information storage unit 13 has a function of storing data, and is, for example, storage means such as a semiconductor memory or a hard disk drive. Deletion character information is stored in the deletion character information storage unit 13 when, for example, a character code of each character configuring deletion character information is stored in the deletion character information storage unit 13. In addition, the deletion character information storage unit 13 has, for example, a stack data structure.

The control unit 14 is connected to the input unit 11, the display unit 12 and the deletion character information storage unit 13, and controls each unit. When the user inputs a character and character information is inputted from the input unit 11, the control unit 14 outputs this character information to the display unit 12. The display unit 12 displays the inputted character information under control of the control unit 14. When the user inputs deletion of a character, too, the control unit 14 controls the display unit 12 to cancel display of the deleted character by outputting this deletion character information to the display unit 12.

Further, the control unit 14 stores deletion character information in the deletion character information storage unit 13 by outputting deletion character information to the deletion character information storage unit 13. The deletion character information storage unit 13 stores the deletion character information in this way. In addition, the control unit 14 has a control function and is, for example, an integrated circuit having a CPU (Central Processing Unit) or the like, yet is not limited to this.

In addition, the character input device 10 may have a character converting function. For example, the input unit 11 has a function of receiving an input of character conversion, and the control unit 14 has a function of performing processing of converting between character types. When the user inputs a character using the input unit 11 and then inputs character conversion, the control unit 14 accesses the storage unit which is not illustrated, and retrieves character information of conversion candidates. In this regard, the storage unit has a function of a database in which various pieces of character information are stored, and stores associated character information of conversion candidates like a dictionary. In addition, the various pieces of character information are pieces of character information such as hiragana, katakana, kanji, alphabet letters, numbers and the like. When character information of a conversion candidate is found, the control unit 14 causes the display unit 12 to display the character information as conversion candidates.

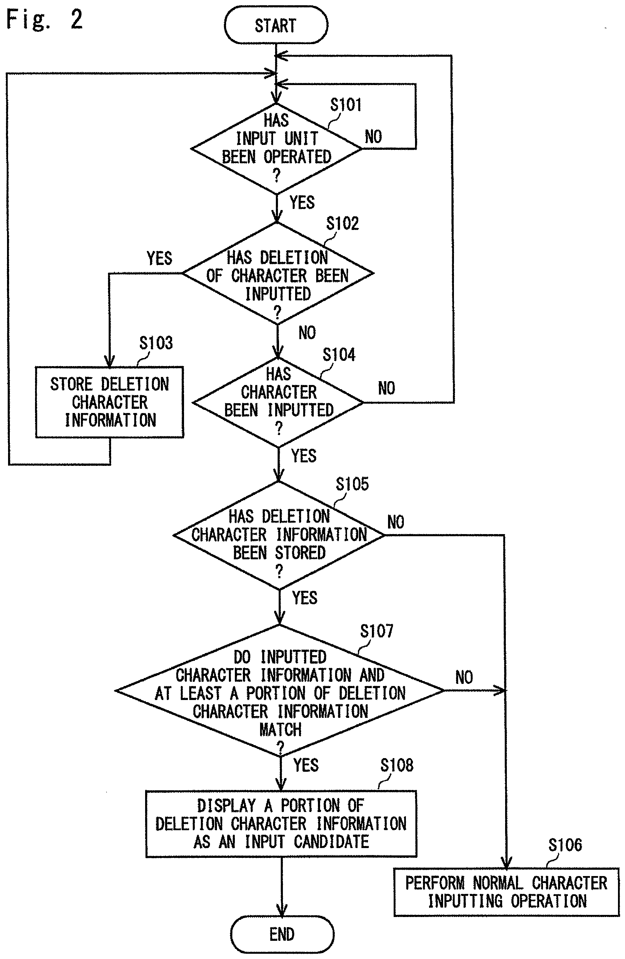

Next, processing of the control unit 14 according to the present embodiment will be described. Fig. 2 is a flowchart illustrating an example of control processing of the control unit 14 in response to an input of a character and an input of deletion through the input unit 11. The control unit 14 performs control for causing the display unit 12 to display a portion of characters deleted by the user by performing processing as described below.

First, the control unit 14 determines whether or not the input unit 11 has been operated, based on a signal from the input unit 11 (step S101). In a case where the input unit 11 has not been operated (No in step S101), the control unit 14 returns to step S101 and performs a determination again.

In a case where the input unit 11 has been operated (Yes in step S101), the control unit 14 determines whether or not deletion of a character has been inputted through the input unit 11 (step S102). For example, the control unit 14 determines whether or not a delete key of the input unit 11 has been pushed, based on the signal from the input unit 11.

In a case where the deletion of the character has been inputted (Yes in step S102), the control unit 14 outputs character information whose deletion has been inputted from the input unit 11, i.e., deletion character information, to the deletion character information storage unit 13, and stores the deletion character information (step S103). After storing (store in the deletion character information storage unit 13) the deletion character information, the control unit 14 determines again whether or not the input unit 11 has been operated (step S101).

In a case where deletion of a character has not been inputted (No in step S102), the control unit 14 determines whether or not a character has been inputted through the input unit 11 (step S104). For example, the control unit 14 determines whether or not a character input key of the input unit 11 has been pushed, based on a signal from the input unit 11.

In a case where a character has not been inputted (No in step S104), the control unit 14 determines again whether or not the input unit 11 has been operated (step S101).

In a case where a character has been inputted (Yes in step S104), the control unit 14 accesses the deletion character information storage unit 13, and determines whether or not deletion character information has been stored in deletion character information storage unit 13 (step S105).

In a case where deletion character information has not been stored in the deletion character information storage unit 13 (No in step S105), the control unit 14 performs a normal character inputting operation (step S106). The "normal character inputting operation" described herein refers to an operation (processing) for causing the display unit 12 to display a character inputted through the input unit 11 as is.

When deletion character information is stored in the deletion character information storage unit 13 (Yes in step S105), the control unit 14 determines whether or not inputted character information and at least a portion of deletion character information stored in the deletion character information storage unit 13 match (step S107). In other words, the control unit 14 determines whether or not the entirety of the inputted character information is included as is as a character string in the deletion character information. In addition, "at least a portion of deletion character information" refers to, for example, a head character of the deletion character information.

When the inputted character information and at least the portion of the deletion character information do not match (No in step S107), the control unit 14 performs the normal character inputting operation. That is, when the entirety of the inputted character information is not included in the deletion character information or is not included as is as a character string, the control unit 14 performs the normal character inputting operation.

When the inputted character information and at least the portion of the deletion character information match (Yes in step S107), the control unit 14 causes the display unit 12 to display a portion of the deletion character information as an input candidate (step S108). That is, when determining that the entirety of the inputted character information is included as is as a character string in the deletion character information, the control unit 14 causes the input candidate to be displayed.

Processing of the control unit 14 illustrated in Fig. 2 will be described by a specific example. The user inputs in advance a character string " 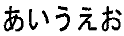 " using the input unit 11. The display unit 12 displays the inputted character string " 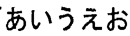 ". Then, the user inputs a deletion using the input unit 11 to delete only a character string " 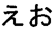 " of the character string " 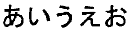 " and leaves a character string " 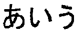 ". However, the user deletes the entirety of the character string " 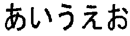 " by mistake, and therefore inputs characters again. The processing of the control unit 14 will be described supposing the case of the above example.

First, the user operates the input unit 11 and deletes the entirety of the character string " 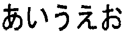 ".

Then, the control unit 14 determines whether or not the input unit 11 has been operated (step S101 in Fig. 2). The control unit 14 determines that the input unit 11 has been operated (Yes in step S101), and then determines whether or not deletion of a character has been inputted (step S102). The user deletes the character string " 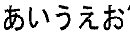 ", and therefore the control unit 14 determines that deletion of a character has been inputted (Yes in step S102). Then, the control unit 14 stores the character string " 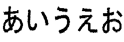 " as deletion character information in the deletion character information storage unit 13 (step S103).

Next, the user inputs a character " 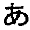 " by operating the input unit 11 to input again the character string " 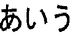 " which has been deleted by mistake.

Then, the control unit 14 determines whether or not the input unit 11 has been operated (step S101 in Fig. 2). The control unit 14 determines that the input unit 11 has been operated (Yes in step S101), and next determines whether or not deletion of a character has been inputted (step S102). The user inputs character " 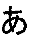 ", and then the control unit 14 determines that deletion of a character has not been inputted (No in step S102). The control unit 14 determines whether or not a character has been inputted (step S104), and determines that the character has been inputted (Yes in step S104).

Subsequently, the control unit 14 determines whether or not deletion character information has been stored in the deletion character information storage unit 13 (step S105 in Fig. 2). The control unit 14 determines that deletion character information " 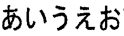 " has been stored in the deletion character information storage unit 13 (Yes in step S105).

Subsequently, the control unit 14 determines whether or not the inputted character information and at least a portion of the deletion character information stored in the deletion character information storage unit 13 match (step S107 in Fig. 2). The inputted character information is " 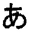 ", and the deletion character information stored in the deletion character information storage unit 13 is " 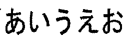 ". In view of the above, the control unit 14 determines that the inputted character information " 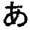 " and a portion " 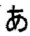 " of the deletion character information match (Yes in step S107 in Fig. 2). That is, the entirety of the inputted character information " 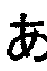 " is included as is as the character " 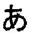 " in the deletion character information " 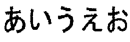 ", and then the control unit 14 causes an input candidate to be displayed.

In view of the above, the control unit 14 causes the display unit 12 to display portions of the deletion character information " 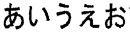 " as the input candidate (step S108 in Fig. 2). In this example, the control unit 14 can cause " 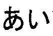 ", " 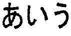 " and " 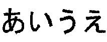 " which are portions including " 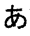 " of " 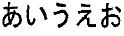 " to be displayed in this order as input candidates.

The user can input the character string " 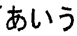 " again by operating the input unit 11 and selecting " 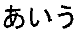 " from the displayed input candidates.

In addition, even when the user inputs the character string " 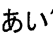 " after deleting the character string " 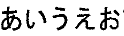 ", the control unit 14 determines in step S107 in Fig. 2 that the inputted character information " 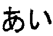 " and a portion " 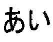 " of the deletion character information " 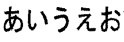 " match. That is, the entirety of the inputted character information " 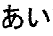 " is included as is as the character string " 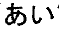 " in the deletion character information " 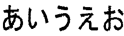 ". Hence, in step S108, the control unit 14 causes " 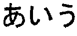 " and " 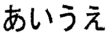 " which are portions including " 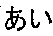 " to be displayed in this order as input candidates.

Further, when the user inputs a character string " 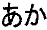 " after deleting the character string " 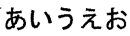 ", the control unit 14 determines in step S107 in Fig. 2 that inputted character information " 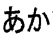 " and portions of the deletion character information " 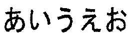 " do not match. That is, the entirety of the inputted character information " 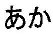 " is not included in the deletion character information " 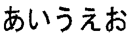 ". Hence, the control unit 14 performs normal character input processing without performing control for displaying a portion of deletion character information as an input candidate.

In addition, even when the user inputs " 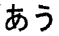 " instead of " 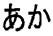 ", the control unit 14 determines in step S107 in Fig. 2 that the inputted character information " 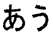 " and portions of the deletion character information " 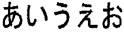 " do not match. In this case, " 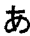 " and " 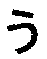 " of the inputted character information are each included in the deletion character information " 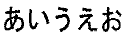 ". However, " 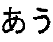 " is not included as is as a character string in the deletion character information " 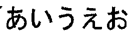 ". Hence, the control unit 14 performs normal character input processing without performing control for displaying a portion of deletion character information as an input candidate.

In this way, the user can input again necessary characters which are a portion of a character string which has been deleted, by inputting only characters which are a portion of deletion character information. Compared to a case where the user has to input all necessary characters again by him/herself, it is possible to reduce labor required to input the characters and easily input the characters again. When the number of characters to be inputted again is increased, this effect becomes more significant.

The character input device 10 according to the present embodiment is not provided with a dedicated key and thus the cost of the character input device is lower compared to a case where a dedicated key for displaying a deleted character string again is provided for a character input device. Further, the input unit 11 occupies a smaller space in the character input device 10. When the character input device 10 is a device such as a mobile terminal, a small PC or a game machine, the device is required to have a smaller size in particular, and therefore this effect is particularly significant. The user does not need to operate the dedicated key, and can easily input a character string again.

The specific example of a hiragana string " 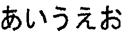 " has been described as deletion character information to describe the processing of the control unit 14. However, even when deletion character information is katakana, kanji, alphabet letters, numbers or the like, it is possible to input deleted characters again by the same processing. Further, even when hiragana, katakana, kanji, alphabet letters, the numbers and the like are mixed in deletion character information, it is possible to input deleted characters again likewise.

For example, a case where a character string " 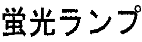 " is stored as deletion character information in the character input device 10 which can convert characters will be described. When the user inputs characters " 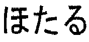 ", inputted character information " 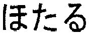 " and a portion of deletion character information " 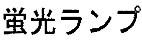 " do not match. Hence, the control unit 14 does not perform control for causing the display unit 12 to display a portion of the deletion character information " 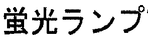 " as an input candidate.

However, when the user converts the character string " 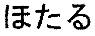 " into " 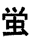 ", the converted character information " 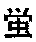 " and a portion " 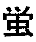 " of the deletion character information " 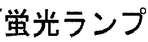 " match. Hence, the control unit 14 performs control for causing the display unit 12 to display a portion (e.g. " 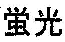 ") of the deletion character information " 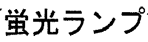 " as an input candidate.

In addition, even when the user converts a character string " 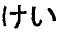 " into " 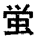 ", the control unit 14 causes the display unit 12 to display a portion of the deletion character information " 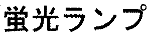 " as an input candidate. However, the number of kanji characters pronounced as " 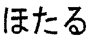 " is smaller than the number of kanji characters pronounced as " 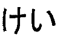 ". Hence, a time the user takes to convert " 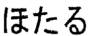 " into " 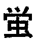 " is assumed to be shorter than a time the user takes to convert " 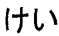 " into " 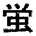 ". The user can display a portion of the deletion character information " 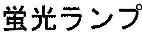 " as an input candidate with less labor by predicting such a time required for conversion and inputting " 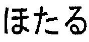 ".

In another example, when the character string " 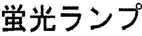 " is stored as deletion character information, even if the user inputs " 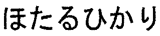 ", the control unit 14 does not perform control for causing the display unit 12 to display a portion of the deletion character information " 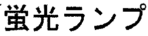 " as an input candidate. This is because inputted character information " 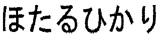 " and portions of the deletion character information " 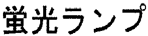 " do not match.

However, when the user converts " 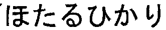 " into " 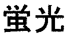 ", converted character information " 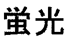 " and a portion " 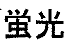 " of the deletion character information " 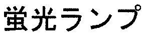 " match. Hence, the control unit 14 performs control for causing the display unit 12 to display a portion (e.g. " 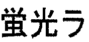 ") of the deletion character information " 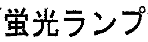 " as an input candidate. Thus, the user can also display a portion of deletion character information by inputting a pronunciation of two or more kanji characters, and converting into the characters.

In this way, the user can display a kanji character by inputting an arbitrary pronunciation of the kanji character in a character string to be inputted again and converting the pronunciation. Consequently, it is possible to easily input a portion of deletion character information again.

In the above example, at a stage at which the user inputs characters " 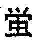 " or " 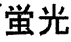 ", the control unit 14 causes a portion of the deletion character information " 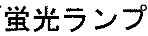 " to be displayed. That is, at a stage at which it is predicted that the user has an intention to input a portion of the deletion character information " 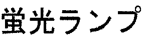 " again, the control unit 14 causes a portion of " 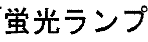 " to be displayed. In view of the above, the character input device 10 can more reliably detect that the user has an intention to input a portion of deletion character information again, and allows the user to easily input the portion of the deletion character information again. In addition, the above description is an example showing conversion of kanji characters, yet is also applicable to conversion of other types of characters.

In addition, the following change can be applied to the processing of the control unit 14 illustrated in Fig. 2.

The order of the steps of the processing of the control unit 14 illustrated in Fig. 2 may be optionally rearranged. For example, the order of step S102 and step S104 illustrated in Fig. 2 may be reversed.

In step S102 in Fig. 2, deletion character information stored in the deletion character information storage unit 13 may be deletion character information in a case where a determined character is deleted, or deletion character information in a case where an undetermined character is deleted.

In step S107 in Fig. 2, the control unit 14 may determine whether or not inputted character information and a head character of deletion character information stored in the deletion character information storage unit 13 match. When, for example, deletion character information is " 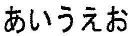 ", and inputted character information is " 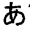 " and matches the head character of the deletion character information, the control unit 14 performs an operation as indicated in step S108 in Fig. 2. However, when inputted character information is " 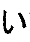 " and does not match the head character of the deletion character information, the control unit 14 performs the normal character input processing. Thus, when inputted character information and a head character of deletion character information do not match, the control unit 14 may determine that the user does not have an intention to input a portion of the deletion character information again, and perform control for preventing the portion of the deletion character information from being displayed.

In step S108 in Fig. 2, the control unit 14 does not need to display all patterns of portions of deletion character information as input candidates. When, for example, deletion character information is " 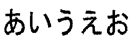 " and inputted character information is " 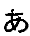 ", the control unit 14 may perform control for displaying an arbitrary one of " 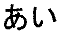 ", " 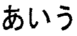 " and " 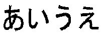 ". Further, the control unit 14 may cause the entirety of the character string " 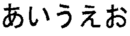 " of the deletion character information to be displayed as an input candidate, too similar to " 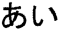 " and " 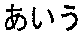 ", which are portions of the deletion character information.

### Second Embodiment

A character input device according to the present embodiment stores deleted deletion character information, and displays a portion of the deletion character information as an input candidate when inputted character information and at least a portion of character information for conversion-inputting the deletion character information match. Consequently, a user can easily input only necessary characters again instead of all the characters in a deleted character string. The embodiment of the present invention will be described below with reference to the drawings. In addition, "character information for conversion-inputting deletion character information" will be optionally abbreviated as "conversion character information" below.

The second exemplary embodiment of the present invention will be described below with reference to the drawings. In addition, descriptions the same as those of the first embodiment will be optionally omitted.

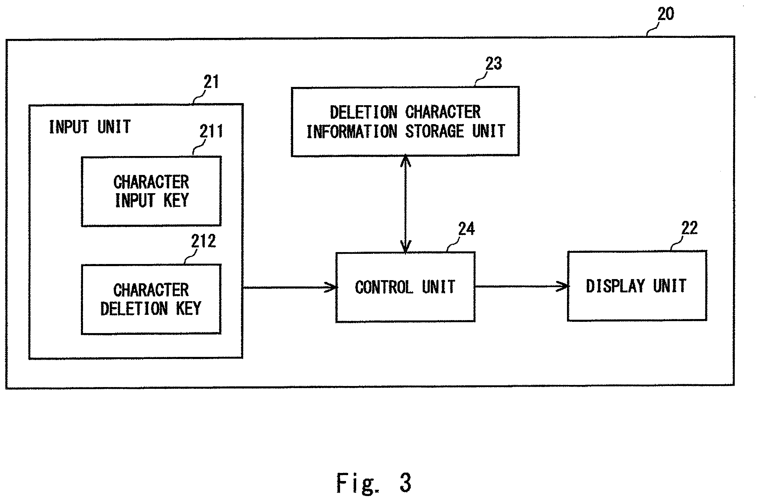

Fig. 3 is a block diagram illustrating an entire configuration example of a mobile terminal according to the present embodiment. A mobile terminal 20 according to the present embodiment has an input unit 21, a display unit 22, a deletion character information storage unit 23 and a control unit 24.

The input unit 21 refers to a plurality buttons provided for the mobile terminal 20, and includes character input keys 211 and a character delete key 212. The character input keys 211 receive user's inputs of characters, and outputs character information to the control unit 24. The character delete key 212 receives a user's input of deletion of a character, and outputs deletion character information to the control unit 24.

The display unit 22 is a liquid crystal display, and displays characters inputted through the input unit 21 and cancels display of a character deleted by the input unit 21.

The deletion character information storage unit 23 is a memory provided for the mobile terminal 20, and stores deletion character information deleted in response to a user's input of a deletion through the input unit 21. Further, the deletion character information storage unit 23 outputs stored deletion character information under control of the control unit 24.

Furthermore, the deletion character information storage unit 23 may store at least a portion of conversion character information. In addition, the conversion character information is one of character information for conversion-inputting the entirety of deletion character information and character information for conversion-inputting a portion of deletion character information (e.g. a head character of the deletion character information). Alternatively, the conversion character information may include both of these pieces of character information.

In addition, the deletion character information storage unit 23 includes a stack data structure such as FILO (First in Last out) or LIFO (Last in First out). Further, the above-described character information is stored in the deletion character information storage unit 23 based on, for example, a character code.

The control unit 24 is a CPU provided in the mobile terminal 20. The control unit 24 is connected to the input unit 21, the display unit 22 and the deletion character information storage unit 23, and controls each of these units. The specific control processing is the same as that in the first embodiment and therefore will not be described.

Further, the control unit 24 has a function of obtaining at least a portion of conversion character information. For example, the mobile terminal 20 has a storage unit which is not illustrated and in which character information and character information for conversion-inputting the character information are associated and stored. The control unit 24 obtains at least a portion of conversion character information by retrieving the conversion character information from the storage unit.

In this regard, the control unit 24 may store a plurality of candidates including at least a portion of conversion character information obtained in this way, in the deletion character information storage unit 23. When, for example, the deletion character information is inputted from the input unit 21, the control unit 24 retrieves and obtains a plurality of candidates including at a least portion of the conversion character information, and stores a plurality of candidates in the deletion character information storage unit 23. In other words, a user's input of a deletion of characters through the input unit 21 may trigger the control unit 24 to generate a plurality of candidates including at least a portion of the conversion character information and store the candidates in the deletion character information storage unit 23. The control unit 24 can obtain one of the candidates stored as described above by accessing the deletion character information storage unit 23.

The mobile terminal 20 optionally has a radio circuit which performs wireless communication, a speaker, a microphone or the like in addition to each of the above units.

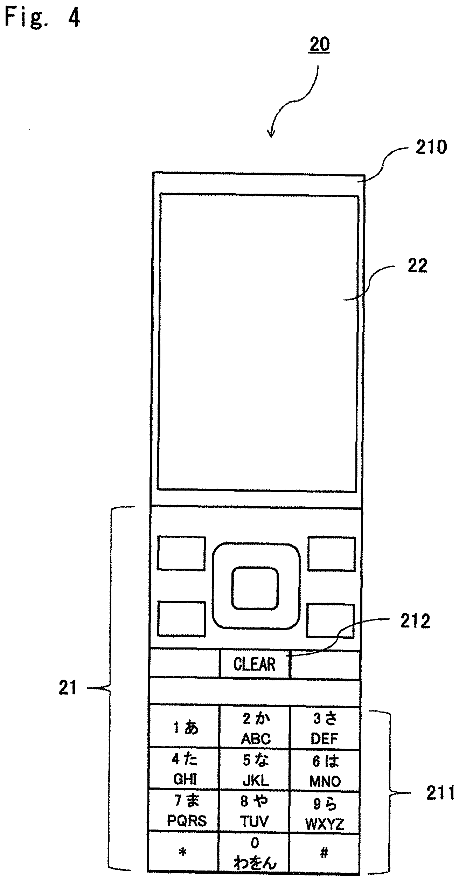

Fig. 4 is an example of the mobile terminal 20 according to the present embodiment. Fig. 4 illustrates a so-called folding mobile telephone as the mobile terminal 20. The display unit 22 is provided at an upper portion of a housing 210, and the input unit 21 is provided at a lower portion of the housing 210. A clear key is provided as the character delete key 212 at a center of the input unit 21, and the character input keys 211 which enable inputs of hiragana, katakana, alphabet letters, numbers and other symbols are provided at a lower portion of the input unit 21. Further, the deletion character information storage unit 23 and the control unit 24 are provided inside the housing 210.

In addition, the character input keys 211 are character input keys which operate like a toggle. When, for example, a key with "1" and " 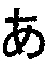 " printed thereon among the character input keys 211 is continuously pushed to input hiragana, a character displayed on the display unit 22 changes in order from " 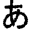 ", " 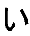 " " 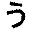 ", " 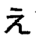 " , " 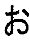 " " 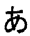 " and " 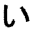 " like a toggle.

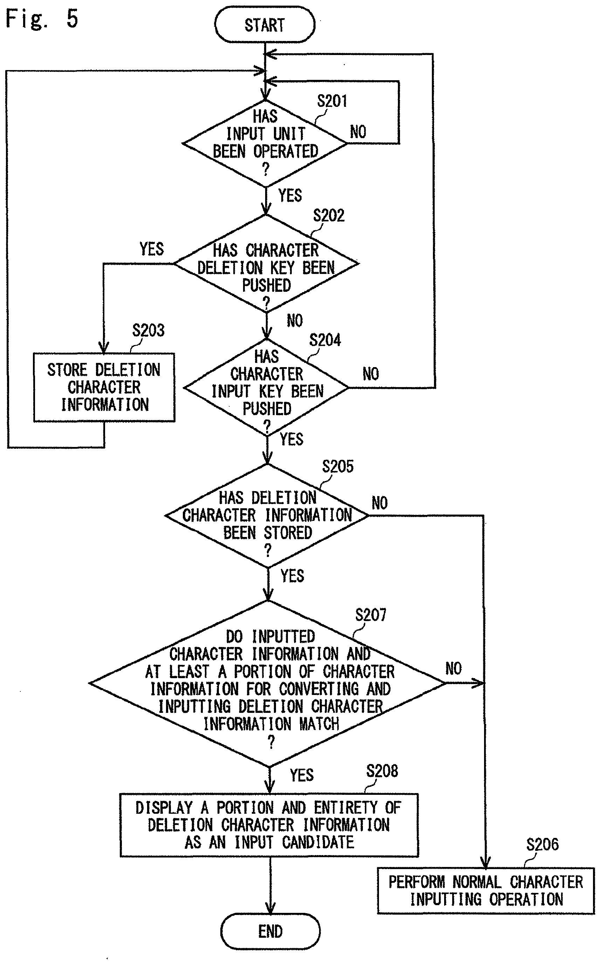

Next, processing of the control unit 24 according to the present embodiment will be described. Fig. 5 is a flowchart illustrating an example of control processing of the control unit 24 in response to an input of a character or an input of a deletion through the input unit 21. The control unit 24 performs control for causing the display unit 22 to display a portion of characters deleted by the user by performing the processing as described below.

The processing of the control unit 24 in steps S201 to S206 in Fig. 5 is the same as the processing of the control unit 14 in steps S101 to S106 in Fig. 2, and therefore will not be described. In, for example, step S202, the control unit 24 determines whether or not the character delete key 212 has been pushed, based on a signal from the character delete key 212. In step 204, too, the control unit 24 performs the similar processing.

In step S205, in a case where deletion character information is stored in the deletion character information storage unit 23 (Yes in step S205), the control unit 24 obtains at least a portion of conversion character information. A method of obtaining the conversion character information is as described above.

Further, the control unit 24 determines whether or not inputted character information and at least a portion of conversion character information (character information for conversion-inputting the deletion character information) match (step S207). In other words, the control unit 24 determines the entirety of the inputted character information is included as is as a character string in conversion character information.

In a case where the inputted character information and at least a portion of the conversion character information do not match (No in step S207), the control unit 24 performs normal character input processing (step S206). That is, in a case where the entirety of the inputted character information is not included in the conversion character information or is not included as is as a character string, the control unit 24 performs the normal character inputting processing.

In a case where the inputted character information and at least a portion of the conversion character information match (Yes in step S207), the control unit 24 causes the display unit 22 to display a portion of the deletion character information as an input candidate (step S208). That is, when determining that the entirety of the inputted character information is included as is as a character string in the conversion character information, the control unit 24 causes the display unit 22 to display the input candidate.

Processing of the control unit 24 illustrated in Fig. 5 will be described by a specific example. The user inputs in advance a character string " 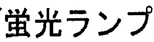 " using the character input keys 211. The display unit 22 displays the inputted character string " 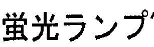 ". Then, the user operates the character delete key 212 to delete only a character string portion " 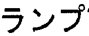 " of the character string " 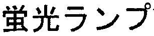 " and leave a character string " 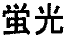 ". However, the user deletes the entirety of the character string " 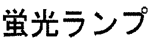 " by mistake, and therefore inputs characters again. The processing of the control unit 24 will be described supposing the case of the above example.

First, the user operates the character delete key 212 and deletes the entirety of the character string " 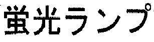 "

Then, the control unit 24 performs the processing in steps S201 to S203 in Fig. 5 similar to the control unit 14 in Fig. 2.

Next, the user inputs a character " 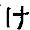 " by operating the character input key 211 to input again the character string " 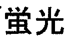 " which has been deleted by mistake.

Then, the control unit 24 performs the processing in steps S201, S202, S204 and S205 in Fig. 5 similar to the control unit 14 in Fig. 2.

Subsequently, the control unit 24 determines whether or not the inputted character information and at least a portion of the conversion character information match (step S207 in Fig. 5). In this regard, the inputted character information is " 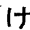 ", and the deletion character information stored in the deletion character information storage unit 23 is " 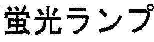 ". " 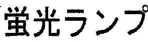 " is converted based on character information such as " 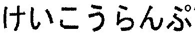 " and " 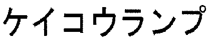 " and inputted. The inputted character information " 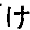 " matches a portion " 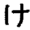 " of the character information (conversion character information) " 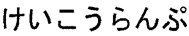 " for conversion-inputting the deletion character information " 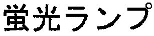 ".

In view of the above, the control unit 24 determines that the inputted character information and portions of the deletion character information match (Yes in step S207 in Fig. 5). For example, the control unit 24 obtains the portion " 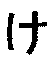 " of the character information " 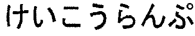 " for conversion-inputting the stored deletion character information " 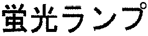 ", from the deletion character information storage unit 23, and determines that this " 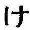 " matches the inputted character information " 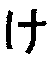 ".

In view of the above, the control unit 24 causes the display unit 22 to display a portion and the entirety of the deletion character information " 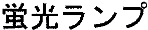 " as the input candidates (step S208 in Fig. 5). In this example, the control unit 24 can cause " 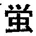 ", " 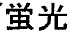 ", " 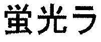 ", " 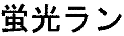 " and " 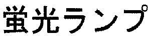 " to be displayed in this order as input candidates. In addition, positions at which input candidates are displayed on the display unit 22 are not limited as long as the user can select the input candidates from these positions.

The user can input the character string " 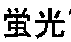 " again by operating the input unit 21 and selecting " 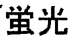 " from the displayed input candidates.

In this way, the user can easily input again necessary characters which are a portion of a character string which has been deleted, by inputting only characters which are a portion of character information for conversion-inputting deletion character information.

In addition, even when the user deletes the character string " 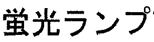 " and then inputs a character string " 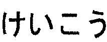 ", it is determined that inputted character information " 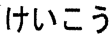 " and a portion " 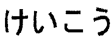 " of conversion character information " 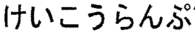 " match. That is, the entirety of the inputted character information " 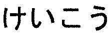 " is included as is as the character string " 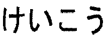 " in the conversion character information " 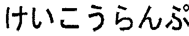 ". Hence, in step S208 in Fig. 5, the control unit 24 causes " 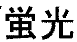 ", " 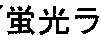 ", " 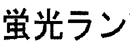 " and " 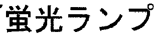 " which are portions and the entirety of deletion character information including " 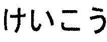 " to be displayed as input candidates.

In addition, character information for conversion-inputting the deletion character information " 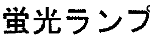 " may include character information " 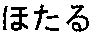 " for conversion-inputting a head character " 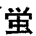 " of " 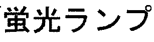 ". Hence, when the user deletes " 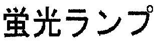 " and then inputs " 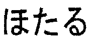 ", the control unit 24 determines that a character string " 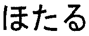 " matches character information " 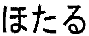 " for conversion-inputting the deletion character information. Then, the control unit 24 causes a portion of " 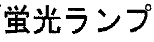 " to be displayed as an input candidate.

Alternatively, at a stage at which the user inputs " 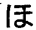 ", the control unit 24 may determine that " 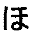 " matches a portion of the character information " 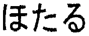 " and causes a portion of " 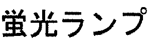 " to be displayed as an input candidate. Thus, even when character information for conversion-inputting a portion of deletion character information does not match a pronunciation of the deletion character information itself, the user can easily input a portion of the deletion character information again by inputting the entirety or a portion of the character information for conversion-inputting a portion of the deletion character information.

By so doing, the user can more easily input a portion of deletion character information. For example, a case where the user inputs " 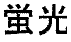 " of the deletion character information " 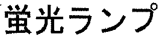 " again will be assumed. In this regard, when the user does not know the pronunciation of " 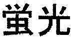 ", the user can easily input " 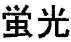 " again by inputting the entirety (e.g. " 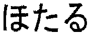 ") or a portion (e.g. " 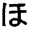 ") of an arbitrary pronunciation of a kanji character " 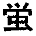 " at a head of " 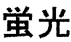 ". Additionally, there may be a case where the user wants to input a kanji phrase again, yet does not know a pronunciation of this kanji phrase. Even in such a case, the user can easily input this kanji phrase again by inputting another pronunciation of a head kanji character.

Generally, when a user inputs the entirety of a character string including kanji characters again, a time is required not only to input a character string itself but also to convert into the kanji characters. However, according to the present embodiment, the user can easily input a character string including a kanji character again without converting into the kanji character. In addition, the mobile terminal 20 according to the present embodiment provides the same effect as that of a character input device 10 according to the first embodiment.

Further, the control unit 24 is triggered by an input of a deletion of a character to generate a plurality of candidates including at least a portion of conversion character information, and store the candidates in the deletion character information storage unit 23. A specific method of generating and storing the candidate is as described above. By this means, it is possible to provide an effect of performing processing of quickly displaying an input candidate as described below.

For example, in step S202 in Fig. 5, the deletion character information " 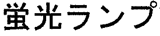 " is inputted from the character delete key 212. In this case, the control unit 24 retrieves character information such as " 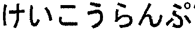 " and " 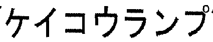 " for conversion-inputting " 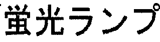 ", from the storage unit which is not illustrated. Further, in step S203, the control unit 24 stores a plurality of candidates such as " 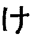 " and " 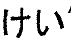 " which are at least a portion of character information " 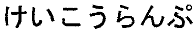 " together with the deletion character information " 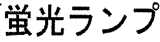 " in the deletion character information storage unit 23. Alternatively, the control unit 24 may store the character information " 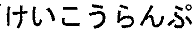 " in the deletion character information storage unit 23. The same also applies to the character information " 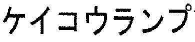 ".

Alternatively, the control unit 24 may store a plurality of candidates including at least portions of " 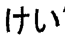 " and " 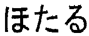 " for conversion-inputting " 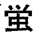 " which is a head character of the deletion character information " 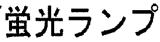 ", in the deletion character information storage unit 23. In addition, the control unit 24 may store a plurality of candidates including at least portions such as " 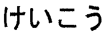 " and " 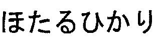 " for conversion-inputting " 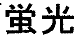 ", in the deletion character information storage unit 23. The control unit 24 performs the above processing in steps S202 and S203.

Next, the user inputs " 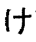 ". In this case, the control unit 24 determines that the deletion character information " 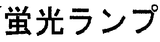 " is stored in the deletion character information storage unit 23, by performing the processing in steps S201, S202, S204 and S205.

In S207 in Fig. 5, the control unit 24 determines whether or not one of a plurality of candidates stored in advance in the deletion character information storage unit 23 matches the inputted character " 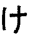 ". In this case, the control unit 24 only needs to sequentially determine whether or not one of the candidates stored in the deletion character information storage unit 23 and the inputted character " 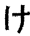 " match.

In step S207 in Fig. 5, in a case where the candidates are not stored in advance in the deletion character information storage unit 23, the control unit 24 needs to obtain the candidates in step S207. That is, more time to obtain the candidates is required before input candidates are displayed in response to a user's input of a character. However, when the candidates are stored in advance in the deletion character information storage unit 23, such time is not required.

In view of the above, the mobile terminal 20 can provide an effect of quickly displaying an input candidate.

In addition, a kanji and katakana character string " 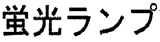 " has been described as a deletion character information in the above example. The above example is also applicable to conversion related to other character types. Even when, for example, hiragana, alphabet letters, numbers or the like are mixed in deletion character information, it is possible to input characters again likewise.

Further, even when Japanese words are inputted using Roman characters in a character input device such as a PC, the processing described in the above example is applicable. When, for example, " 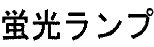 " is stored as deletion character information, character information of Roman characters for conversion-inputting " 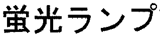 " is "keikourannpu". When the user deletes the character string " 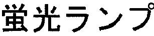 " and then inputs "k", the control unit 24 determines that "k" matches a portion of "keikourannpu", and displays " 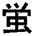 ", " 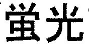 ", " 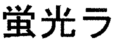 " and " 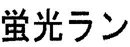 " which are portions of the deletion character information " 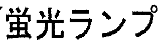 " as input candidates.

In addition, the deletion character information storage unit 23 outputs deletion character information in an order of newly deleted characters. For example, the user deletes characters in an order of " 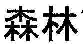 ", " 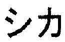 " and " 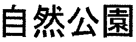 ". Subsequently, when the user inputs " 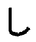 ", the deletion character information storage unit 23 outputs deletion character information in an order of " 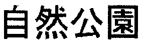 ", " 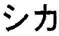 " and " 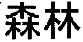 ". Then, the control unit 24 causes " 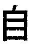 ", " 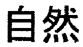 ", " 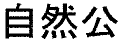 " and " 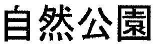 " which are portions or the entirety of " 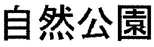 " to be displayed in this order as input candidates. Next, the control unit 24 causes " 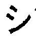 " and " 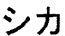 " which are portions and the entirety of " 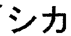 " and finally " 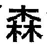 " and " 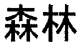 " to be displayed in this order as input candidates. This is because the deletion character information storage unit 23 includes a stack data structure. The same also applies to a case where the deletion character information storage unit 13 includes a stack data structure as in the first embodiment.

In addition, the same change as that described above in the first embodiment is applicable to the processing of the control unit 24 illustrated in Fig. 5.

For example, in step S206 in Fig. 5, the control unit 24 may determine whether or not inputted character information and a head character of deletion character information stored in the deletion character information storage unit 23 match. When, for example, deletion character information is " 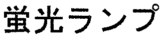 " and inputted character information is " 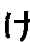 " the control unit 24 performs processing of displaying input candidates as described above. However, when the inputted character information is " 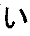 ", the control unit 24 may perform normal character input processing. In addition, when the inputted character information is " 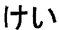 ", the control unit 24 performs processing of displaying input candidates. However, when the inputted character information is " 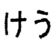 ", the control unit 24 performs normal character input processing. This is as described in the first embodiment.

In step S207 in Fig. 5, the control unit 24 does not need to cause all patterns of portions of deletion character information to be displayed as input candidates. When, for example, deletion character information is " 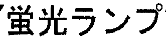 " and inputted character information is " 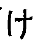 ", the control unit 24 may perform control for causing an arbitrary one of " 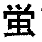 ", " 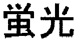 ", " 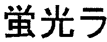 " and " 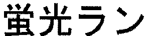 " to be displayed as an input candidate. The entirety of the character string " 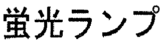 " of the deletion character information may not be displayed as an input candidate.

The specific example of the input unit 21, the display unit 22, the deletion character information storage unit 23 and the control unit 24 described in the present embodiment may be other specific examples as long as the input unit 21, the display unit 22, the deletion character information storage unit 23 and the control unit 24 perform the same processing as that described above. Further, the character input device is not limited to the mobile terminal described as an example of said device, and may be other devices such as a game machine and a PC which allow users to input characters.

### Third Embodiment

A character input device according to the present embodiment changes at least an input candidate to be displayed, in response to a direction from which deletion character information is deleted. Consequently, a user can more accurately input again only characters which have been deleted by mistake.

A character input device 10 according to the present embodiment has an input unit 11, a display unit 12, a deletion character information storage unit 13 and a control unit 14.

The deletion character information storage unit 13 stores deletion direction information indicating whether deletion character information has been deleted from a head or a tail of deletion character information upon storage of the deletion character information. When, for example, the deletion character information is deleted, the control unit 14 determines which delete key of the input unit 11 is used for deletion, based on a signal from the input unit 11. By this means, the control unit 14 generates deletion direction information. The control unit 14 outputs this deletion direction information to and stores it in the deletion character information storage unit 13. By this means, the deletion character information storage unit 13 stores the deletion direction information.

In addition, a method of deleting characters can delete characters from the tail by using, for example, a backspace key of a keyboard, and delete characters from the head by using a delete key. When a signal is outputted from the backspace key, the control unit 14 determines that the deletion character information has been deleted from the tail based on this signal. The control unit 14 generates deletion direction information indicating that the deletion character information has been deleted from the tail, based on the above determination. When a signal is outputted from the delete key, the control unit 14 determines that the deletion character information has been deleted from the head based on this signal. The control unit 14 generates deletion direction information indicating that the deletion character information has been deleted from the head, based on the above determination. In addition, according to a character deleting method other than the method using the delete key, the control unit 14 can also determine from which direction deletion character information has been deleted by determining which portion of the input unit 11 has been operated. Consequently, it is also possible to generate deletion direction information.

The control unit 14 optionally changes a portion of deletion character information to be displayed as an input candidate, by determining whether deletion character information has been deleted from the head or the tail of the deletion character information, based on the deletion direction information.

The other operation of each unit of the character input device 10 according to the present embodiment is the same as that in the first embodiment, and will not be described.

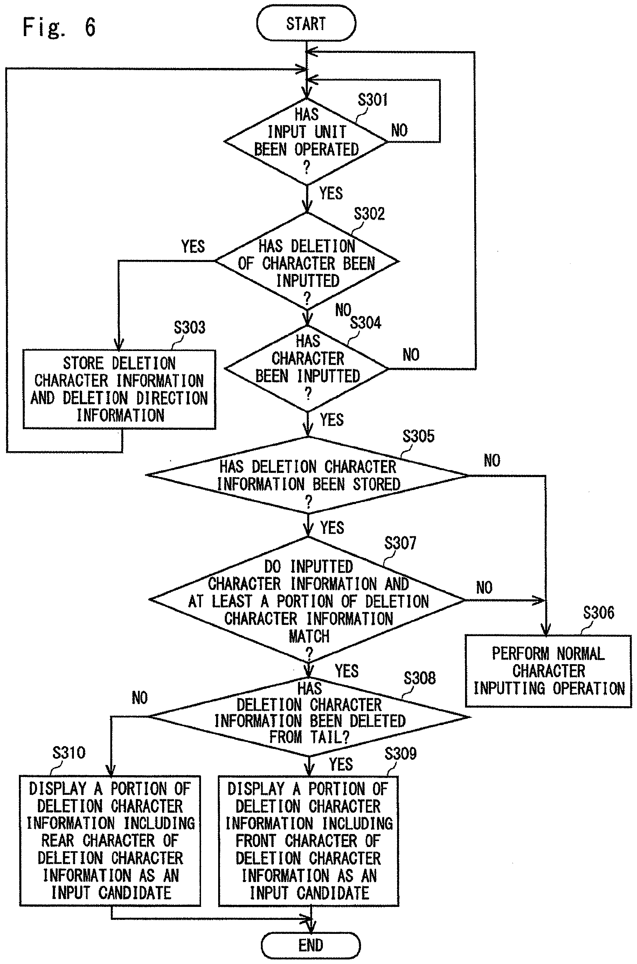

Next, processing of the control unit 14 according to the present embodiment will be described. Fig. 6 is a flowchart illustrating an example of control processing of the control unit 14 in response to an input of a character and an input of a deletion through the input unit 11. The control unit 14 performs control for causing the display unit 12 to display a portion of characters deleted by the user by performing the processing as described below.

Processing in steps S301 and S302 in Fig. 6 is the same as the processing in steps S101 and S102 in Fig. 2, and therefore will not be described.

In step S303, the control unit 14 stores deletion character information, and deletion direction information indicating whether the deletion character information has been deleted from the head or the tail, in the deletion character information storage unit 13. A method of generating deletion direction information in the control unit 14 is as described above.

Processing in steps S304 to S307 in Fig. 6 is the same as the processing in steps S104 to S107 in Fig. 2, and therefore will not be described.

In step S307, when the control unit 14 determines that inputted character information and at least a portion of deletion character information match (Yes in step S307), the control unit 14 determines whether or not the deletion character information whose match has been determined has been deleted from the tail (step S308). The control unit 14 performs this determination in step S308 by accessing the deletion character information storage unit 13 and obtaining deletion direction information stored together with the deletion character information in step S303.

When the control unit 14 determines that the deletion character information has been deleted from the tail (Yes in step S308), the control unit 14 causes the display unit 12 to display a portion of the deletion character information including a character on the front side of the deletion character information, as at least an input candidate (step S309).

When the control unit 14 determines that the deletion character information has been deleted from the head (No in step S308), the control unit 14 causes the display unit 12 to display a portion of the deletion character information including a character on the rear side of the deletion character information as at least an input candidate (step S310).

The processing of the control unit 14 illustrated in Fig. 6 will be described by a specific example. The user inputs in advance a character string " 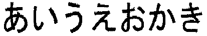 " using the input unit 11. The display unit 12 displays the inputted character string " 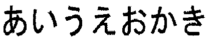 ". Then, the user inputs deletion using the input unit 11 to delete only a character string portion " 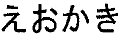 " of the character string " 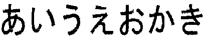 " and leave a character string " 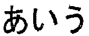 ". However, although the user tries to delete " 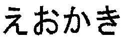 " from the tail using the backspace key, the user has deleted the entirety of the character string " 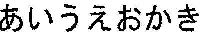 " by mistake, and therefore inputs characters again. The processing of the control unit 14 will be described supposing the case of the above example.

First, the user operates the backspace key of the input unit 11 and deletes the entirety of the character string " 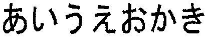 ".

In step S303, the control unit 14 stores deletion character information " 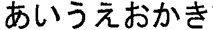 " and deletion direction information indicating that " 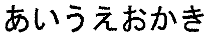 " has been deleted from the tail, in the deletion character information storage unit 13. In addition, the control unit 14 generates deletion direction information indicating that the deletion character information has been deleted from the tail based on a signal outputted from the backspace key, and outputs the deletion direction information to the deletion character information storage unit 13. Processing in steps S301 and S302 of the control unit 14 is as described above.

Next, the user inputs a character " 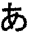 " by operating the input unit 11 to input again the character string " 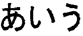 " which has been deleted by mistake.

Here, the control unit 14 performs processing in steps S301, S302 and S304 to S307 in Fig. 6. In step S307, the control unit 14 determines that inputted character information " 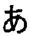 " and a portion " 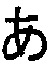 " of deletion character information " 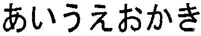 " match (Yes in step S307).

Next, the control unit 14 determines whether or not the deletion character information " 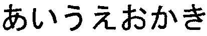 " has been deleted from the tail (step S308).

By obtaining deletion direction information stored in the deletion character information storage unit 13, the control unit 14 determines that the deletion character information " 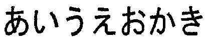 " has been deleted from the tail (Yes in step S308). In view of the above, the control unit 14 causes the display unit 12 to display at least a portion including a character on the front side of the deletion character information " 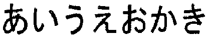 " as an input candidate (step S309). In this example, the control unit 14 causes " 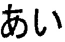 " and " 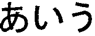 " to be displayed as input candidates.

The user can input the character string " 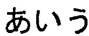 " again by operating the input unit 11 and selecting " 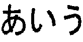 " from the displayed input candidates.

In the above example, the control unit 14 determines that a character string which the user tries to input again (a character string has been deleted by the user by mistake) is on the front side of the deletion character information based on the fact that the user has deleted the deletion character information from the tail. Based on this above determination, the control unit 14 causes at least a portion including a character on the front side of the deletion character information to be displayed as an input candidate. By this means, a character which is assumed to be inputted again by the user is more accurately displayed as an input candidate.

In addition, the "a character on the front side" of the deletion character information refers to, for example, character information of a first half of the deletion character information. Alternatively, the "a character on the front side" may refer to character information from one character to several characters including the foremost portion of the deletion character information.

In contrast with the above, an example of a case where the user has deleted the character string " 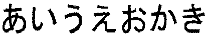 " from the head will be described. In this case, in step S303, the control unit 14 stores the deletion character information " 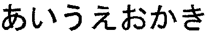 " and deletion direction information indicating that " 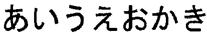 " has been deleted from the head, in the deletion character information storage unit 13. Generating the deletion direction information is done as described above.

Subsequently, when the user inputs a character " 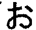 " again, in step S307, the control unit 14 performs the above match determination. Further, in step S308, the control unit 14 determines whether or not the deletion character information " 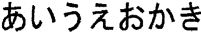 " has been deleted from the head, based on deletion direction information.

The deletion character information " 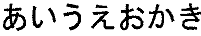 " has been deleted from the head (No in step S308), and therefore the control unit 14 causes the display unit 12 to display at least a portion of the deletion character information including a character on the rear side of the deletion character information " 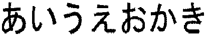 " as an input candidate. In this example, the control unit 14 causes " 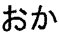 " and " 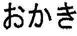 " to be displayed as input candidates.

When the user wants to input " 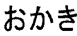 " again, the user can input a character string " 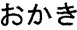 " again by operating the input unit 11 and selecting " 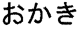 " from the displayed input candidates.

In addition, the "a character on the rear side" of the deletion character information refers to, for example, character information of a second half of the deletion character information. Alternatively, the "a character on the rear side" may refer to character information from one character to several characters including the last portion of the deletion character information.

As described above, the control unit 14 changes an input candidate to be displayed, in response to a direction from which deletion character information has been deleted. Consequently, it is possible to more accurately display a desired character string which the user wants to input again, as an input candidate.

In addition, the processing described in the present embodiment is also applicable to the character input device described in the second embodiment. When, for example, the user deletes " 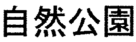 " from the tail and character information inputted after the deletion is " 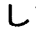 ", the control unit 24 causes the display unit 22 to display a portion of deletion character information including characters on the front side of the deletion character information, such as " 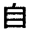 " and " 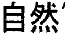 " of the deletion character information " 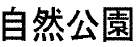 ", by performing the same processing as that described above. When the user wants to input " 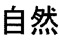 " again, the user only needs to select " 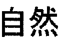 " from displayed input candidates.

### Fourth Embodiment

A character input device according to the present embodiment causes a portion of deletion character information to be displayed as an input candidate in order from a smaller number of characters. Consequently, it is possible to more accurately input again only characters deleted by a user by mistake.

A character input device 10 according to the present embodiment has an input unit 11, a display unit 12, a deletion character information storage unit 13 and a control unit 14. An operation of each of these units is the same as that in the first embodiment, and therefore will not be described.

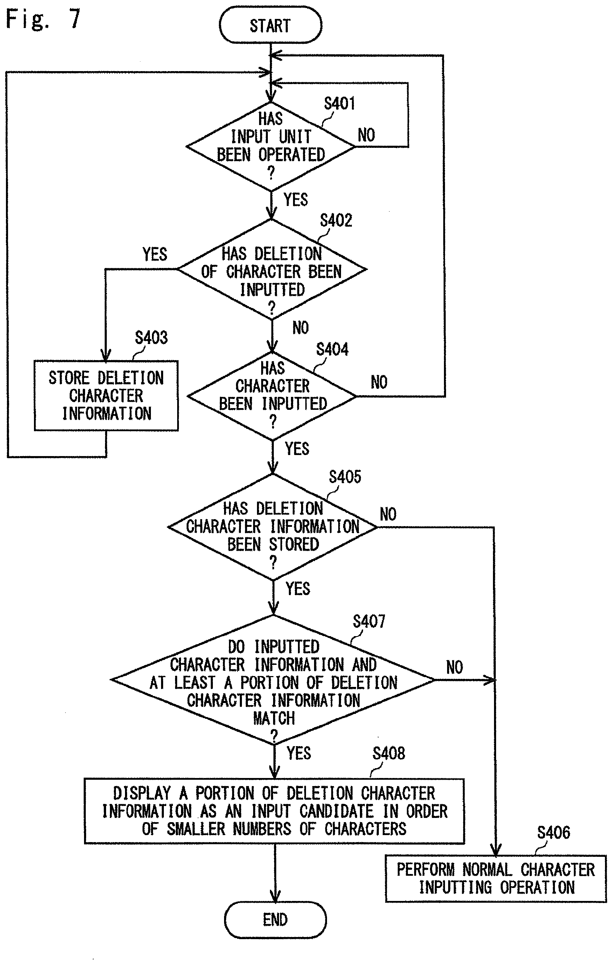

Next, processing of the control unit 14 according to the present embodiment will be described. Fig. 7 is a flowchart illustrating an example of control processing of the control unit 14 in response to an input of a character and an input of a deletion through the input unit 11.

Processing in steps S401 to S407 in Fig. 7 is the same as processing in steps S101 to S107 in Fig. 2, and therefore will not be described.

In step S407, when the control unit 14 determines that inputted character information and at least a portion of deletion character information match (Yes in step S407), the control unit 14 causes a portion of the deletion character information to be displayed in order from a smaller number of characters.

When, for example, deletion character information " 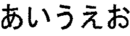 " is stored in the deletion character information storage unit 13 and a character inputted by the user is " 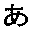 ", the control unit 14 displays input candidates in an order of " 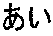 ", " 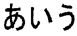 " and " 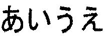 ".

Alternatively, when the deletion character information " 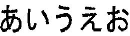 " is stored in the deletion character information storage unit 13 and a character inputted by the user is " 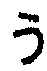 ", the control unit 14 displays input candidates in an order of " 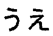 " and " 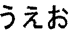 ".

It is considered that the number of characters to be deleted by a user by mistake is generally a small number of characters of from one character to about several characters. In other words, it is assumed that the number of characters to be inputted again by the user is not many. In view of the above, the control unit 14 preferentially displays smaller numbers of characters among portions of deletion character information as input candidates, so that the user can input desired characters again without looking at the latter parts of the displayed input candidates. That is, the character input device according to the present embodiment can eliminate a user's labor of inputting characters again.

The processing of the control unit described in the present embodiment may be performed together with processing of the control unit described in the third embodiment. Consequently, it is possible to eliminate a user's labor of inputting characters again.

In addition, the present invention is not limited to the above embodiments, In other words, various changes which one of ordinary skill in the art can understand can be applied to the configurations and the details of the present invention within the scope of the appended claims. For example, the character input device may perform operations described in the first and second embodiments. That is, the control unit of the character input device may determine whether or not character information inputted by the input unit and at least a portion of deletion character information or at least a portion of character information for conversion-inputting the deletion character information match. When determining that the character information and at least a portion of deletion character information or at least a portion of character information match, the control unit causes the display unit to display a portion of deletion character information as an input candidate.

When, for example, deletion character information is " 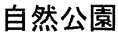 ", if the user inputs characters such as " 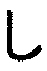 ", " 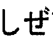 " and "s", the control unit causes the display unit to display a portion of the deletion character information " 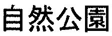 " as an input candidate. Alternatively, after the user inputs " 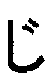 ", even if the control unit converts " 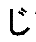 " into " 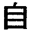 " and causes the display unit to display " 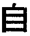 ", the control unit causes the display unit to display a portion of the deletion character information " 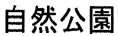 " as an input candidate. Details of the above processing are as described in the first and second embodiments.

Further, in the first, second, third or fourth embodiment, the following processing of the deletion character information storage unit and the control unit may be added.

The control unit may delete deletion character information stored in the deletion character information storage unit, from the deletion character information storage unit at an adequate timing. For example, a case where, in step S107 in Fig. 2 and step S207 in Fig. 5, a character inputted by the user and portions of deletion character information deleted by the user do not match will be assumed. In this case, the control unit may delete deletion character information from the deletion character information storage unit by determining that the user does not intend to input a character again at this point in time. Alternatively, in step S108 in Fig. 2 and step S208 in Fig. 5, after deletion character information is displayed as an input candidate, the control unit may determine that the user does not use deletion character information again, and delete the displayed deletion character information from the deletion character information storage unit.

Even when a plurality of candidates including at least portions of conversion character information are stored in the deletion character information storage unit, the character input device described in the second embodiment may likewise delete a plurality of candidates at adequate timings. In addition, in this case, compared to a case where only deletion character information is stored in the deletion character information storage unit, the amount of information stored in the deletion character information storage unit per input of deletion increases. Hence, compared to a case where only the deletion character information is stored, information stored in the deletion character information storage unit may be more frequently deleted.

The character input device may be caused to execute the above operations of the character input device according to the present invention as control programs. In other words, the present invention can also achieve a processing process disclosed in, for example, the flowchart of Fig. 2, 5, 6 or 7 by causing a CPU to execute computer programs. Further, the above programs can be stored using various types of non-transitory computer readable media, and be supplied to a computer (character input device). The non-transitory computer readable media include various types of tangible storage media. The non-transitory computer readable media include, for example, magnetic recording media (e.g. a flexible disk, a magnetic tape and a hard disk drive), a magnetooptical recording medium (e.g. magnetooptical disk), a CD-ROM (Read Only Memory), a CD-R, a CD-R/W, and semiconductor memories (e.g. a mask ROM, a PROM (Programmable ROM), a EPROM (Erasable PROM), a flash ROM and a RAM (Random Access Memory)). Further, the programs may be supplied to computers through various types of transitory computer readable media. The transitory computer readable media include, for example, an electrical signal, an optical signal and an electromagnetic wave. The transitory computer readable media can supply the programs to computers through wired communication paths such as wires and optical fibers or wireless communication paths.

The above-described character input device is also optionally applicable to character input devices which receive inputs of not only the Japanese language but also other languages.

### Industrial Applicability

The present invention is applicable to a character input device, a character input method of the character input device and a non-transitory computer readable medium.

### Reference Signs List

- 10: Character Input Device
- 11: Input Unit
- 12: Display Unit
- 13: Deletion Character Information Storage Unit
- 14: Control Unit
- 20: Mobile Terminal
- 21: Input Unit
- 22: Display Unit
- 23: Deletion Character Information Storage Unit
- 24: Control Unit
- 210: Housing
- 211: Character Input Key
- 212: Character Delete Key

## Claims

1. A character input device (10) comprising:
input means (11) configured to receive an input of a character and an input of a command to delete the character;
display means (12) configured to display the character inputted through the input means (11);
deletion character information storage means (13, 23) for storing a deletion character string deleted from a character string in response to the input of the command to delete the deletion character string through the input means (11); and
control means (14, 24) configured to access the deletion character information storage means (13,23) and to determine whether or not a character inputted through the input means (11) and at least a portion of the deletion character string stored in the deletion character information storage means (13, 23) match, and to display a portion of the deletion character string as an input candidate on the display means (12) when a match has been determined; **characterised in that** the deletion character information storage means (13, 23) is further configured to store deletion direction information indicating whether the deletion character string has been deleted from the beginning or the end of the string, and wherein the control means (14, 24) is configured to determine whether the deletion character string has been deleted from the beginning or the end of the string based on the deletion direction information of the deletion character information storage means (13, 23) when a match has been determined,
the displayed portion of the deletion character string including the inputted character on the end of the deletion character string as an input candidate, when determining that the deletion character string has been deleted from the beginning, and the displayed portion of the deletion character string including the inputted character on the beginning of the deletion character string as an input candidate, when determining that the deletion character string has been deleted from the end.

2. The character input device (10) according to Claim 1, wherein
the input means (11) is further configured to receive an input of a command which convert the character string inputted through the input means to kanji characters, and
the control means (14, 24) is configured to determine whether or not the character that is inputted through the input means (11) and is converted and at least the portion of the deletion character string stored in the deletion character information storage means (13, 23) match.

3. The character input device (10) according to Claim 1 or 2, wherein the control means (14, 24) is configured to display portions of the deletion character string as the input candidates in order from smaller numbers of characters.

4. A character input method of a character input device (10) comprising:
storing a deletion character string and deletion direction information indicating whether the deletion character string has been deleted from the beginning or the end of the string;
determining whether or not a character inputted after the deletion and at least a portion of the stored deletion character information match; and **characterized in that** the method comprises:
determining whether the deletion character string has been deleted from the beginning or the end of the string based on the deletion direction information stored when determining the match,
displaying at least a portion of the deletion character string including the inputted character on the end of the deletion character string as an input candidate when determining that the deletion character string has been deleted from the beginning, and
displaying at least a portion of the deletion character information including the inputted character on the beginning of the deletion character string as an input candidate when determining that the deletion character information has been deleted from the end.

5. A non-transitory computer readable medium having stored thereon a program causing a character input device (10) to perform the method according to Claim 4.

## Patentansprüche

1. Zeicheneingabevorrichtung (10), mit:
einer Eingabeeinrichtung (11), die dafür konfiguriert ist, eine Eingabe eines Zeichens und eine Eingabe eines Befehls zum Löschen des Zeichens zu empfangen;
einer Anzeigeeinrichtung (12), die dafür konfiguriert ist, das über die Eingabeeinrichtung (11) eingegebene Zeichen anzuzeigen;
einer Löschzeicheninformationsspeichereinrichtung (13, 23) zum Speichern einer Löschzeichenfolge, die in Antwort auf die Eingabe des Befehls zum Löschen der Löschzeichenfolge über die Eingabeeinrichtung (11) von einer Zeichenfolge gelöscht wurde; und
einer Steuereinrichtung (14, 24), die dafür konfiguriert ist, auf die Löschzeicheninformationsspeichereinrichtung (13, 23) zuzugreifen und zu bestimmen, ob ein über die Eingabeeinrichtung (11) eingegebenes Zeichen und mindestens ein Abschnitt der in der Löschzeicheninformationsspeichereinrichtung (13, 23) gespeicherten Löschzeichenfolge übereinstimmen, und einen Abschnitt der Löschzeichenfolge als einen Eingabekandidaten auf der Anzeigeeinrichtung (12) anzeigen, wenn eine Übereinstimmung festgestellt wurde;
**dadurch gekennzeichnet, dass**
die Löschzeicheninformationsspeichereinrichtung (13, 23) ferner dafür konfiguriert ist, Löschrichtungsinformation zu speichern, die anzeigt, ob die Löschzeichenfolge vom Anfang oder vom Ende der Zeichenfolge gelöscht worden ist, und
wobei die Steuereinrichtung (14, 24) dafür konfiguriert ist, auf der Basis der Löschrichtungsinformation der Löschzeicheninformationsspeichereinrichtung (13, 23) zu bestimmen, ob die Löschzeichenfolge vom Anfang oder vom Ende der Zeichenfolge gelöscht worden ist, wenn eine Übereinstimmung festgestellt worden ist,
der angezeigte Abschnitt der Löschzeichenfolge das eingegebene Zeichen am Ende der Löschzeichenfolge als einen Eingabekandidat enthält, wenn festgestellt wird, dass die Löschzeichenfolge vom Anfang gelöscht wurde, und
der angezeigte Abschnitt der Löschzeichenfolge das eingegebene Zeichen am Anfang der Löschzeichenfolge als einen Eingabekandidat enthält, wenn festgestellt wird, dass die Löschzeichenfolge vom Ende gelöscht worden ist.

2. Zeicheneingabevorrichtung (10) nach Anspruch 1, wobei
die Eingabeeinrichtung (11) ferner dafür konfiguriert ist, eine Eingabe eines Befehls zum Umwandeln der über die Eingabeeinrichtung eingegebenen Zeichenfolge in Kanji-Zeichen zu empfangen, und
die Steuereinrichtung (14, 24) dafür konfiguriert ist, zu bestimmen, ob das Zeichen, das über die Eingabeeinrichtung (11) eingegeben und umgewandelt wird, und mindestens der Abschnitt der in der Löschzeicheninformationsspeichereinrichtung (13, 23) gespeicherten Löschzeichenfolge übereinstimmen.

3. Zeicheneingabevorrichtung (10) nach Anspruch 1 oder 2, wobei
die Steuereinrichtung (14, 24) dafür konfiguriert ist, Abschnitte der Löschzeichenfolge als die Eingabekandidaten in der Folge ausgehend von kleineren Zeichenzahlen anzuzeigen.

4. Zeicheneingabeverfahren für eine Zeicheneingabevorrichtung (10), mit den Schritten:
Speichern einer Löschzeichenfolge und von Löschrichtungsinformation, die anzeigt, ob die Löschzeichenfolge vom Anfang oder vom Ende der Zeichenfolge gelöscht worden ist;
Bestimmen, ob ein nach dem Löschen eingegebenes Zeichen und mindestens ein Abschnitt der gespeicherten Löschzeicheninformation übereinstimmen; und
**dadurch gekennzeichnet, dass** das Verfahren die Schritte aufweist:
Bestimmen, ob die Löschzeichenfolge vom Anfang oder vom Ende der Zeichenfolge gelöscht worden ist, basierend auf der gespeicherten Löschrichtungsinformation, wenn die Übereinstimmung festgestellt wird;
Anzeigen mindestens eines Abschnitts der Löschzeichenfolge, der das eingegebene Zeichen am Ende der Löschzeichenfolge enthält, als einen Eingabekandidaten, wenn festgestellt wird, dass die Löschzeichenfolge vom Anfang gelöscht worden ist; und
Anzeigen mindestens eines Abschnitts der Löschzeicheninformation, der das eingegebene Zeichen am Anfang der Löschzeichenfolge enthält, als einen Eingabekandidaten, wenn festgestellt wird, dass die Löschzeicheninformation vom Ende gelöscht worden ist.

5. Nichtflüchtiges computerlesbares Speichermedium, in dem ein Programm gespeichert ist, das eine Zeicheneingabevorrichtung (10) veranlasst, das Verfahren nach Anspruch 4 auszuführen.

## Revendications

1. Dispositif de saisie de caractères (10) comprenant :
un moyen d'entrée (11) configuré pour recevoir une saisie d'un caractère et une saisie d'une commande de suppression du caractère ;
un moyen d'affichage (12) configuré pour afficher le caractère saisi par le biais du moyen d'entrée (11) ;
un moyen de stockage d'informations de caractère à supprimer (13, 23) destiné à stocker une chaîne de caractères à supprimer supprimée d'une chaîne de caractères en réponse à la saisie de la commande afin de supprimer la chaîne de caractères à supprimer par le biais du moyen d'entrée (11) ; et
un moyen de commande (14, 24) configuré pour accéder au moyen de stockage d'informations de caractères à supprimer (13, 23) et pour déterminer si un caractère saisi par le biais du moyen d'entrée (11) et au moins une partie de la chaîne de caractères à supprimer stockée dans le moyen de stockage d'informations de caractères à supprimer (13, 23) correspondent ou non, et pour afficher une partie de la chaîne de caractères à supprimer comme un candidat d'entrée sur le moyen d'affichage (12) lorsqu'une correspondance a été déterminée ;
**caractérisé en ce que**
le moyen de stockage d'informations de caractères à supprimer (13, 23) est en outre configuré pour stocker des informations de direction de suppression qui indiquent si la chaîne de caractères à supprimer a été supprimée du début ou de la fin de la chaîne, et
dans lequel le moyen de commande (14, 24) est configuré pour déterminer si la chaîne de caractères à supprimer a été supprimée du début ou de la fin de la chaîne sur la base des informations de direction de suppression du moyen de stockage d'informations de caractères à supprimer (13, 23) lorsqu'une correspondance a été déterminée,
la partie affichée de la chaîne de caractères à supprimer comprenant le caractère saisi à la fin de la chaîne de caractères à supprimer comme candidat d'entrée, lorsqu'il est déterminé que la chaîne de caractères à supprimer a été supprimée du début, et
la partie affichée de la chaîne de caractères à supprimer comprenant le caractère saisi au début de la chaîne de caractères à supprimer comme candidat d'entrée, lorsqu'il est déterminé que la chaîne de caractères à supprimer a été supprimée de la fin.

2. Dispositif de saisie de caractères (10) selon la revendication 1, dans lequel
le moyen d'entrée (11) est en outre configuré pour recevoir la saisie d'une commande qui convertit la chaîne de caractères saisie par le biais du moyen d'entrée en caractères kanji, et
le moyen de commande (14, 24) est configuré pour déterminer si le caractère qui est saisi par le biais du moyen d'entrée (11) et qui est converti et au moins la partie de la chaîne de caractères à supprimer stockée dans le moyen de stockage d'informations de caractères à supprimer (13, 23) correspondent ou non.

3. Dispositif de saisie de caractères (10) selon la revendication 1 ou 2, dans lequel le moyen de commande (14, 24) est configuré pour afficher des parties de la chaîne de caractères à supprimer comme candidats d'entrée, en partant des nombres de caractères les plus petits.

4. Procédé de saisie de caractères d'un dispositif de saisie de caractères (10) comprenant :
le stockage d'une chaîne de caractères à supprimer et d'informations de direction de suppression qui indiquent si la chaîne de caractères à supprimer a été supprimée du début ou de la fin de la chaîne ;
la détermination du fait qu'un caractère saisi après la suppression et qu'au moins une partie des informations de caractères à supprimer stockées correspondent ou non ; et
**caractérisé en ce que** le procédé comprend :
la détermination du fait que la chaîne de caractères à supprimer ait été supprimée du début ou de la fin de la chaîne sur la base des informations de direction de suppression stockées lors de la détermination de la correspondance,
l'affichage d'au moins une partie de la chaîne de caractères à supprimer, y compris le caractère saisi à la fin de la chaîne de caractères à supprimer comme un candidat d'entrée lorsqu'il est déterminé que la chaîne de caractères à supprimer a été supprimée du début, et
l'affichage d'au moins une partie des informations de caractères à supprimer, y compris du caractère saisi au début de la chaîne de caractères à supprimer comme candidat d'entrée lorsqu'il est déterminé que les informations de caractères à supprimer ont été supprimées de la fin.

5. Support non-transitoire lisible par un ordinateur qui stocke un programme qui permet à un dispositif de saisie de caractères (10) d'exécuter le procédé selon la revendication 4.
